# FASCICULE DE BREVET EUROPEEN

(11) **EP 2 887 532 B1**
(45) Date de publication et mention de la délivrance du brevet: **23.08.2017**
(21) Numéro de dépôt: 14197867.6
(22) Date de dépôt: 15.12.2014
(51) Int. Cl.: H02N 2/02, H02N 2/06

(54) **Actionneur de précision aller-retour**
Präzisionsstellglied für Vor- und Rückwärtsbewegung
Round-trip precision actuator

(30) Priorité: 18.12.2013 FR 1302978
(43) Date de publication de la demande: 24.06.2015
(73) Titulaire: Thales, 92400 Courbevoie (FR); Cedrat Technologies, 38240 Meylan (FR)
(72) Inventeur: Devilliers, Christophe, 06150 CANNES LA BOCCA (FR); Aguilar, Félix, 06150 CANNES LA BOCCA (FR); Ducarne, Julien, 06150 CANNES LA BOCCA (FR); Barillot, François, 38240 MEYLAN (FR); Claeyssen, Frank, 38240 MEYLAN (FR)
(74) Mandataire: Collet, Alain

(56) Documents cités:
- EP-A1- 2 639 844
- DE-A1- 10 042 941
- SU-A1- 640 385
- US-A- 4 423 347
- US-A- 4 765 140
- US-A1- 2009 167 113

## Description

L'invention concerne un actionneur de précision nanométrique et peut, par exemple, être utilisée dans le domaine spatial pour une application d'optique active.

Un téléscope dispose d'un miroir principal, aussi appelé miroir primaire. Le miroir primaire concentre les rayons lumineux vers un miroir secondaire qui les renvoie au foyer du téléscope. Le miroir primaire ne doit pas se déformer sous l'effet de la gravité par exemple. Souvent, un miroir intermédiaire déformable est utilisé pour corriger les défauts du miroir primaire. Et le miroir intermédiaire est déformé par un ou plusieurs actionneurs.

Pour une application d'optique active, un actionneur de très grande précision et stabilité est recherché. On peut même souhaiter une précision nanométrique, c'est-à-dire de l'ordre du nanomètre. Idéalement, l'actionneur doit fonctionner au mieux autour de sa position initiale. C'est ce que l'on appelle aussi avoir une course symétrique autour du zéro mécanique. Enfin, son coefficient de dilatation, noté CTE dans la littérature anglo-saxonne pour Coefficient of Thermal Expansion, doit être le plus bas possible.

Dans différents domaines d'application, des actionneurs de précision sont requis. Parmi les actionneurs de précision, on peut citer les actionneurs piézoélectriques.

L'effet piézoélectrique direct est la propriété selon laquelle l'application d'une charge mécanique sur certains cristaux ou céramiques fait apparaître des charges électriques à la surface du matériau. L'effet piézoélectrique direct peut être mis à profit dans la réalisation de capteurs tels que les capteurs de pression.

L'effet piézoélectrique inverse est la propriété de déformation d'un matériau piézoélectrique lorsqu'on lui applique un champ électrique. L'effet piézoélectrique inverse permet de réaliser des actionneurs.

Les matériaux piézoélectriques sont très nombreux. Le plus connu est le quartz. Mais ce sont des céramiques synthétiques, les PZT (pour Titano-Zirconate de Plomb, aussi appelées LZT dans la littérature anglo-saxonne pour Lead Zirconate Titanate) qui sont aussi largement utilisées aujourd'hui dans l'industrie.

Il existe principalement deux types d'actionneurs piézoélectriques. Le premier type d'actionneurs est appelé actionneur direct, dans lesquels le déplacement obtenu est égal à la déformation du matériau piézoélectrique. Les actionneurs directs permettent d'obtenir des courses entre 0 et 100 micromètres. Le second type d'actionneurs regroupe les actionneurs amplifiés, dans lesquels un dispositif mécanique vient amplifier ce mouvement, d'un facteur de 2 à 20. Les actionneurs amplifiés ont généralement des courses comprises entre 0,1 mm et 1 mm.

Aujourd'hui, ce sont les céramiques multicouches (aussi appelées MLA pour Multi-Layer Array dans la littérature anglo-saxonne) qui sont traditionnellement utilisées dans les actionneurs piézoélectriques. L'intégration de ce type de matériau impose des précautions spécifiques. On peut citer en particulier la nécessité d'assurer une précontrainte mécanique ou d'éviter les efforts en torsion. Sous réserve d'une bonne conception et utilisation, les actionneurs piézoélectriques sont extrêmement fiables et robustes.

Leur fiabilité et robustesse ont permis aux actionneurs piézoélectriques d'être utilisés dans le domaine spatial. Ils sont également utilisés, par exemple, pour le nanopositionnement, la création de vibrations, le contrôle actif de vibrations.

Aujourd'hui, outre le domaine spatial, les actionneurs piézoélectriques sont utilisés dans plusieurs domaines. On peut notamment citer :
- le monde industriel pour de l'assistance à l'usinage par création de vibrations ;
- la commande de certains injecteurs en automobile réalisée grâce à des matériaux piézoélectriques. Cette technique permet notamment de bien maîtriser le processus d'injection de carburant ;
- certaines imprimantes à jet d'encre utilisant des éléments piézoélectriques pour produire les fines gouttelettes qui sont propulsées sur le papier ;

Actuellement, on utilise un actionneur piézoélectrique avec précontrainte pour déformer le miroir intermédiaire. Au repos, on dit que l'actionneur est à sa position intiale ou de référence, aussi appelée position du zéro mécanique. La course d'un tel actionneur est dissymétrique. Par exemple, l'actionneur a une course comprise en - 5 µm et + 40 µm. La difficulté réside dans le décentrage de la course qui implique d'avoir un offset important de la tension en position centrale. Dans ce cas, la position initiale n'est plus le zéro mécanique souhaité.

Une autre solution consiste à utiliser deux actionneurs associés en opposition (aussi appelé « push-pull » dans la littérature anglo-saxonne) où leurs efforts s'additionnent. Chaque actionneur doit déformer l'autre lorsqu'il est actionné. Cette solution ne permet que des courses réduites. Plus précisément, les actionneurs ont un déplacement complémentaire. Cependant, l'assymétrie du déplacement conduit à un effort résiduel au point milieu ou au repos. Le push-pull série double l'effort à course constante.

Ainsi, on constate que l'utilisation d'un actionneur piézoélectrique seul ne permet pas d'obtenir une course symétrique souhaitée. Il est nécessaire de précontraindre le système et de décaler le zéro mécanique. Cela rend problématique un éventuel cas de panne où l'actionneur se bloque dans une position extrême.

L'utilisation d'un actionneur en « push-pull » est une solution connue et intéressante. Néanmoins, elle réduit la course totale de l'actionneur et impose l'utilisation d'actionneurs encombrants pour obtenir la course souhaitée.

Le brevet US 4 765 140 décrit un mécanisme utilisant des éléments piézo-électriques répartis en deux groupes, auxquels une tension est appliquée, de façon à contrôler le déplacement des éléments.

Le document SU 640 385 divulgue un actionneur de précision. Le document EP2639844 divulge un dispositif de mouvement de précision. Le brevet US 4 423 347 décrit un actionneur comprenant un élément de positionnement formé par deux éléments piézo-électriques, chacun fixé à une extrémité à une base. Les deux éléments sont connectés électriquement. Quand un élément est contracté au maximum, le second élément est allongé à son maximum, et inversement quand le second élément est contracté, le premier élément est en position allongée.

Enfin, l'utilisation d'un actionneur avec un micromoteur, un réducteur et une vis permettant d'obtenir une démultiplication est intéressante. Néanmoins, la démultiplication augmente le besoin en course de l'actionneur qui peut alors devenir trop encombrant. Ce type d'actionneur n'est donc pas envisageable pour une application spatiale.

L'invention vise à pallier tout ou partie des problèmes cités plus haut en proposant un actionneur de précision pouvant fonctionner autour de sa position initiale avec une course symétrique et un coefficient de dilatation contrôlé.

A cet effet, l'invention a pour objet un actionneur selon la revendication indépendante 1. L'invention sera mieux comprise et d'autres avantages apparaîtront à la lecture de la description détaillée d'un mode de réalisation donné à titre d'exemple, description illustrée par le dessin joint dans lequel :
- la figure 1 représente schématiquement un actionneur selon l'invention ;
- la figure 2 représente schématiquement l'alimentation de l'actionneur ;
- la figure 3a représente schématiquement le placement des jauges de déformation sur l'actionneur ;
- la figure 3b illustre le montage en pont complet des jauges de déformation ;
- la figure 4 représente schématiquement un actionneur selon l'invention ;
- la figure 5 représente l'asservissement de la commande de l'actionneur en fonction d'une mesure d'extension de l'actionneur.

Par souci de clarté, les mêmes éléments porteront les mêmes repères dans les différentes figures.

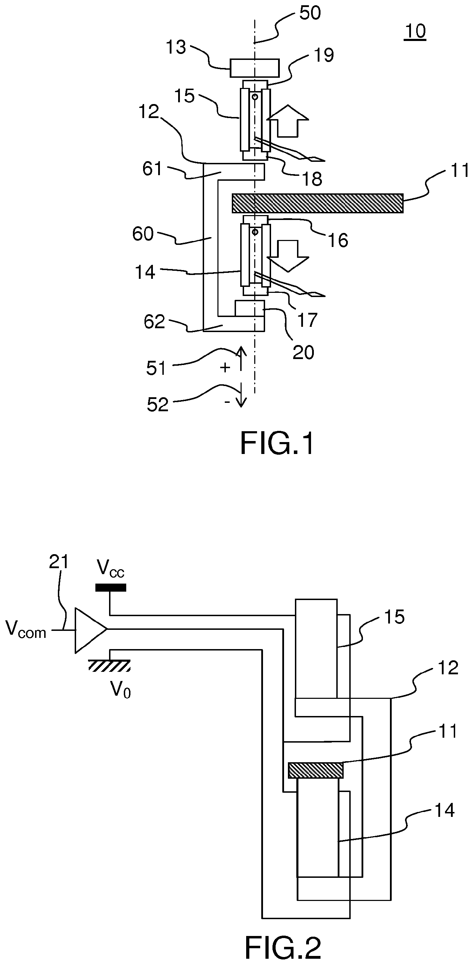

La figure 1 représente schématiquement un actionneur 10 selon l'invention. L'actionneur 10 comprend une base 11, une structure intermédiaire 12, une interface de sortie 13. L'actionneur 10 comprend deux éléments linéaires 14, 15 produisant une extension contrôlable selon une même direction longitudinale 50, chacun entre une première et une seconde extrémité. Un premier 14 des deux éléments possède une première extrémité 16 fixée sur la structure intermédiaire 12 et une seconde extrémité 17 fixée sur la base 11. Un second 15 des deux éléments posséde une première extrémité 18 fixée sur la structure intermédiaire 12 et une seconde extrémité 19 fixée à l'interface de sortie 13. La base 11 et la structure intermédiaire 12 sont positionnées de façon à ce que l'extension contrôlable du second élément 15 produise un déplacement de l'actionneur 10 dans un premier sens 51 et l'extension contrôlable du premier élément 14 produise un déplacement de l'actionneur 10 dans un second sens 52 opposé au premier sens 51 par rapport à la base. Sur la figure 1, deux éléments sont représentés. On pourrait tout à fait imaginer un actionneur comportant plusieurs autres éléments, par exemple 3, 4 ou plus.

La base 11, la structure intermédiaire 12, l'interface de sortie 13 et les deux éléments 14, 15 forment plusieurs composants formant un empilage. Ainsi, lorsque l'élément 15 s'étend, il déplace l'empilage dans le sens 51. Lorsque l'élement 14 s'étend, il déplace la structure intermédiaire 12 dans le sens 52. On obtient ainsi un actionneur capable d'avoir une course symétrique autour de sa position initiale.

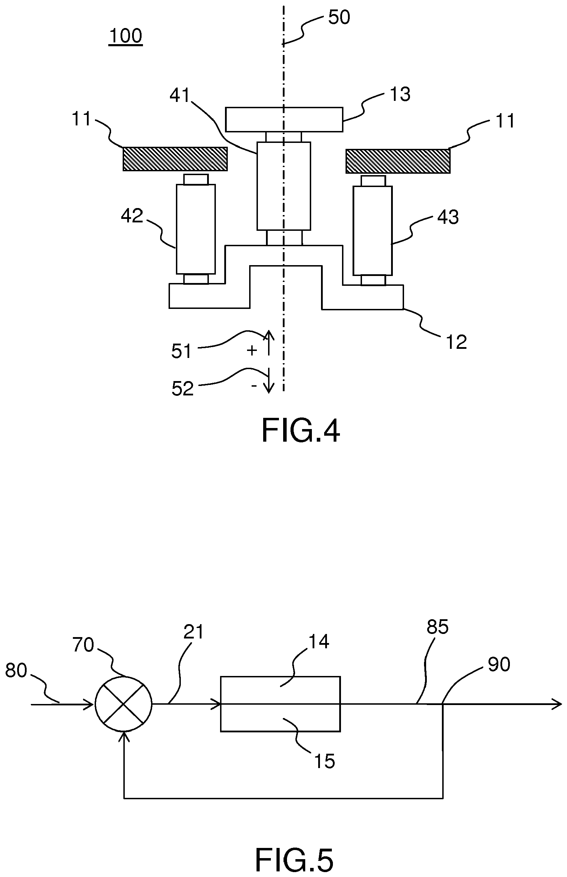

Par ailleurs, la structure intermédiaire 12 peut prendre différentes formes. On peut notamment distinguer une structure intermédiaire dite axiale avec des éléments superposés dans la direction longitudinale (comme c'est le cas sur la figure 1) d'une structure intermédiaire dite latérale comme pour l'actionneur 100 représenté sur la figure 4. L'actionneur 100 est identique à l'actionneur 10 à la différence que l'actionneur 100 comprend trois éléments 41, 42 et 43. Les éléments 41, 42 et 43 sont à extension contrôlable dans la direction longitudinale 50. Ils sont positionnés les uns à côté des autres parallèlement à la direction longitudinale 50. L'élement 41 a une extension contrôlable dans le sens 51 et l'extension des éléments 42 et 43 déplace l'actionneur 100 dans le sens 52. Sur la figure 4, trois éléments sont représentés. L'actionneur 100 pourrait en comprendre plusieurs autres. Par exemple, l'élément 41 pourrait être remplacé par deux éléments. Un actionneur avec une structure intermédiaire dite axiale a un encombrement plus important dans le sens longitudinal, alors qu'un actionneur avec une structure intermédiaire dite latérale a un encombrement moindre dans le sens longitudinal mais plus important dans le sens latéral. En pratique, la forme de la structure intermédiaire 12 est choisie en fonction de l'encombrement dont peut disposer l'actionneur 10 dans son environnement.

La structure intermédiaire 12 est configurée de telle façon que le coefficient de dilatation thermique de l'actionneur 10 ait une valeur prédéterminée. En effet, en choisissant bien les épaisseurs et matériaux de la structure intermédiaire 12, on peut faire en sorte d'obtenir un empilage dit athermique. On considère maintenant une dilatation de l'actionneur 10 soumis à une élévation de température donnée. En se dilatant, l'élément 15 s'allonge d'une distance e dans le sens 51. En choisissant des éléments 14 et 15 identiques ou au moins semblables, l'élément 14 se dilate de la même façon, c'est-à-dire que l'élément 14 se dilate également d'une distance e. Or, l'élément 14 étant positionné entre la base 11 et la structure intermédiaire 12, la dilatation de l'élément 14 résulte en un déplacement de la structure intermédiaire 12 d'une distance e dans le sens 52. La dilatation de l'élément 15 et la dilatation de l'élément 14 se compensent.

Hormis les éléments 14 et 15, on peut réaliser les autres composants de l'empilage dans des matériaux dont les coefficients de dilatation sont les plus faibles possibles. La structure intermédiaire 12 et la base 11 sont par exemple constituées d'un alliage de fer (64%) et de nickel (36%). Cet alliage possède un coefficient de dilatation très faible (1,2.10⁻⁶K⁻¹). La structure intermédiaire 12 et la base 11 peuvent aussi être en céramique, par exemple en nitrure de silicium. L'interface de sortie 13 peut être en verre de type vitrocéramique et dispose également d'un coefficient de dilatation thermique très faible.

On peut choisir des composants de l'empilage ayant des coefficients de dilatation plus élevés tout en conservant pour l'empilage un coefficient de dilatation thermique globalement nul. Il est aussi possible que le coefficient de dilatation thermique de l'empilage soit globalement nul en intercalant des pièces intermédiaires. La structure intermédiaire 12 peut avoir une forme en U composée d'une partie centrale 60 parallèle à la direction longitudinale 50, d'une première partie 61 sur laquelle est fixé le second élément 15 et d'une seconde partie 62 parallèle à la première partie 61, sensiblement perpendiculaires à la partie centrale 60.

En cas de dilatation de la structure intermédiaire 12, c'est la partie 60 qui se dilate de manière significative selon la direction longitudinale 50. L'élément 15 se déplace donc avec la dilatation de la structure intermédiaire 12. L'actionneur 10 peut comporter une cale de réglage thermique 20 positionnée entre deux composants de l'empilage. Avantageusement, la cale 20 de réglage thermique est positionnée entre la seconde partie 62 et le premier élément 14. Autrement dit, la cale 20 est positionnée entre la première extrémité du premier élément 14 et la structure intermédiaire 12. La cale 20 peut être réalisée de sorte à ajuster la longueur de la partie centrale 60 de la structure intermédiaire 12. La cale 20 peut être réalisée dans un matériau à fort coefficient de dilatation thermique. La cale 20 se dilate alors autant que la structure intermédiaire 12 et déplace la structure intermédiaire 12 dans le sens 52 pour contre-balancer le déplacement dans le sens 51 dû à la dilatation de la structure intermédiaire 12. Placée entre l'élément 14 et la structure intermédiaire 12, la cale 20 permet d'obtenir un coefficient de dilatation thermique de l'empilage globalement nul. L'ajustement de la hauteur de la cale 20 règle le coefficient de dilatation de l'empilage aussi bien à la hausse qu'à la baisse.

En fonctionnement, l'élément 14 s'étend au niveau de sa seconde extrémité. On dit qu'il tire sur la structure intermédiaire 12. L'élément 15 monté sur la structure intermédiaire 12 s'étend au niveau de sa seconde extrémité. On dit qu'il pousse l'actionneur. Mécaniquement, chacun des deux éléments 14, 15 assure la moitié de la course. C'est ce qu'on appelle un fonctionnement en « aller-retour ». On obtient ainsi un actionneur 10 avec une course symétrique.

Quand l'actionneur 10 fonctionne dans un environnement subissant des variations de température, les deux éléments 14, 15 se dilatent. Le fonctionnement en aller-retour permet à l'interface de sortie 13 de l'actionneur de rester fixe. Autrement dit, l'actionneur 10 est insensible à une dilatation simultanée des éléments, ce qui lui confère une précision de positionnement.

Les éléments 14, 15 peuvent être à base de matériaux piézoélectriques, magnétostrictifs ou électrostrictifs.

Les éléments 14, 15 peuvent être munis de guidages flexibles permettant de rigidifier l'actionneur 10.

L'actionneur 10 peut être utilisé avec une amplification de course. L'amplification de course se fait grâce à un dispositif mécanique auquel l'actionneur 10 est relié par utilisation d'un bras de levier. L'amplification de course permet d'obtenir une course plus longue au détriment de la raideur et de la précision.

Avantageusement, les éléments 14, 15 sont identiques.

La figure 2 représente schématiquement l'alimentation de l'actionneur 10. L'actionneur 10 comporte une commande commune 21 aux deux éléments 14, 15. La commande 21 est configurée de façon à avoir un premier effet sur un élément et un second effet, inverse au premier effet, sur le second élément. La commande 21 à effet inversé est par exemple réalisée au moyen de trois tensions V0, Vcc et Vcom. Les tensions V0 et Vcom sont fixes et la tension Vcom varie entre V0 et Vcc. L'élément 14 est commandé entre les tensions V0 et Vcom. L'élément 15 est commandé entre les tensions Vcom et Vcc. Ainsi, la tension aux bornes de l'élement 15 est Vcc-Vcom et la tension aux bornes de l'élément 14 est Vcom-V0. La commande commune 21 a une amplitude A voisine de Vcc-Vom. Une position de référence, aussi appelée position initiale ou zéro mécanique, de l'actionneur 10 est définie pour une valeur de commande égale à A/2. La commande commune 21 agit sur Vcom qui va générer une variation de tension positive (respectivement négative) entre les bornes de l'élément 14 (respectivement 15) et inversement. Sous l'effet de cette variation de tension aux bornes de chacun des élements 14, 15, il en résulte une extension (respectivement rétraction) d'un des deux élements. Autrement dit, en faisant varier Vcom négativement par exemple, la tension aux bornes de l'élément 15 croît. L'élément 15 s'étend selon la direction longitudinale 50 dans le sens 51 et déplace ainsi l'interface de sortie d'une distance d/2. En faisant varier Vcom positivement, la tension aux bornes de l'élément 14 croît. L'élément 14 s'étend selon la direction longitudinale 50 dans le sens 51 et, la seconde extrémité de l'élément 14 étant fixée sur la base 11, déplace ainsi la structure intermédiaire 12, c'est-à-dire que l'actionneur 10 se déplace d'une distance d/2 selon la direction longitudinale 50 dans le sens 52. Les courses de chaque élément s'additionnent. L'actionneur 10 a donc une course égale à d. En pratique, on peut obtenir de longues courses, de l'ordre d'une trentaine de micromètres. La course ainsi obtenue va générer un déplacement de l'actionneur 10 permettant de déformer le miroir intermédiaire (non représenté sur la figure 2) dans le sens voulu et avec l'amplitude souhaitée.

La commande commune 21 permet d'obtenir une bonne linéarité autour du zéro mécanique obtenu par l'amplitude A/2, assurant ainsi une grande précision (de l'ordre du nanomètre) et une grande stabilité. En effet, dans le cas d'une alimentation séparée des éléments, et donc d'une commande séparée, il faut basculer d'une commande à une autre, ce qui complexifie la commande.

Par ailleurs, la commande commune 21 simplifie la mise en oeuvre d'un tel actionneur et est particulièrement bénéfique dans le cas où plusieurs actionneurs sont utilisés.

Enfin, en cas de panne, par exemple si l'actionneur 10 n'est plus alimenté, la commande commune 21 est particulièrement intéressante. L'actionneur 10 reste dans sa position de référence au zéro mécanique, alors que dans le cas d'un actionneur ayant par exemple une course comprise entre -5 µm et + 40 µm avec une alimentation séparée, l'actionneur se bloque dans une position extrême.

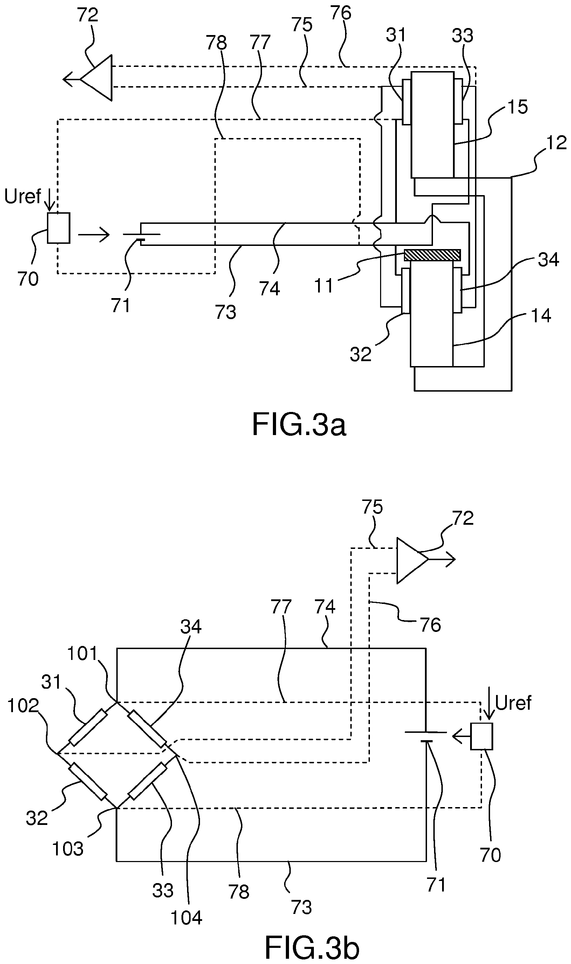

La figure 3a représente schématiquement un exemple de placement de quatre jauges de déformation sur l'actionneur 10. L'actionneur 10 comprend des jauges de déformation montées sur les éléments 14, 15. Les éléments 14, 15 comprennent chacun deux jauges de déformation se déformant en fonction de l'extension des éléments. L'élément 14 comprend deux jauges de déformation 32, 34 et l'élément 15 comprend deux jauges de déformation 31, 33. Les jauges sont connectées de façon à amplifier l'effet en vue d'une mesure de l'extension entre la base 11 et l'interface de sortie 13. Les jauges 31, 32, 33, 34 permettent de mesurer la déformation des éléments 14 et 15 selon la direction longitudinale 50.

Il est à noter qu'une configuration simplifiée à une jauge est également envisageable. On parle dans ce cas de demi-pont. Par contre, cette configuration est sensible à la flexion de l'actionneur.

Une jauge de déformation est un fil résistant très fin imprimé ou collé sur un support isolant placé sur l'élément dont on souhaite quantifier la déformation. Quand le support se déforme, le fil s'étire. Sa résistance électrique varie alors proportionnellement à la variation de longueur. En mesurant la variation de résistance, on en déduit sa déformation, et par là même, la déformation de l'élément. Afin de transmettre le plus fidèlement possible les déformations de l'élément, le support de la jauge doit avoir des caractéristiques bien spécifiques. On peut noter par exemple une bonne aptitude au collage, un coefficient de dilatation faible ainsi qu'une bonne tenue en température.

Les variations de résistance des jauges de déformation sont trop faibles pour être directement mesurables. Les jauges de déformation sont de ce fait assemblées suivant un montage électrique en pont complet qui permet d'accéder à la variation de résistance. Sur la figure 3a, les jauges de déformation 31, 32, 33, 34 sont placées sur les éléments 14, 15 dans les mêmes conditions de collage.

La figure 3b illustre le montage en pont complet des jauges de déformation 31, 32, 33, 34. La jauge 31 se situe entre deux points 101 et 102, la jauge 32 se situe entre deux points 102 et 103, la jauge 33 se situe entre deux points 103 et 104 et la jauge 34 se situe entre les points 104 et 101. Les jauges 31 et 32 sont montées en série entre les points 101 et 103. De même, les jauges 33 et 34 sont montées en série entre les points 101 et 103. La tension aux bornes des jauges 31 et 32 montées en série, qui est la même que la tension aux bornes des jauges 33 et 34, est appelée tension d'alimentation du pont.

Un montage en pont complet permet d'obtenir une sensibilité optimale. Il n'y a pas de biais dans la mesure de l'extension des éléments, le pont est sensible uniquement aux déformations utiles. Autrement dit, en cas de déformation thermique des éléments 14 et 15, les quatre jauges voient leur résistance se modifier simultanément et dans le même sens. Lors d'une telle modification, la tension de sortie du pont reste inchangée. Le pont de jauge est connecté à un comparateur 72 qui alimente le capteur, conditionne et amplifie la valeur de la mesure.

Les figures 3a et 3b représentent également l'alimentation de l'actionneur 10 par un circuit d'alimentation 71. Deux fils 73, 74 alimentent le pont. Deux autres fils 75, 76 restituent le déséquilibre du pont au comparateur 72 lorsque les résistances électriques des jauges varient. Deux autres fils 77, 78, aussi appelés fils de retour, permettent une mesure de la tension d'alimentation entre les points 101 et 103 qui est retournée vers un comparateur 70. Le comparateur 70 agit alors sur le circuit d'alimentation 71 pour maintenir la tension d'alimentation constante. Ce montage à 6 fils permet d'éliminer les pertes en ligne qui peuvent apparaître à cause de la résistance du cablage.

La figure 5 représente l'asservissement de la commande de l'actionneur 10 en fonction d'une mesure 90 d'extension de l'actionneur 10 issue du comparateur. L'actionneur 10 comporte une boucle active fermée entre la commande commune 21 aux deux éléments 14, 15 et la mesure 90 de l'extension des éléments. Pour déformer le miroir intermédiaire dans le sens souhaité, une consigne initiale 80 indique au circuit d'alimentation 71 d'alimenter le pont. Les éléments 14, 15 se déforment selon la direction longitudinale 50 dans le sens souhaité. Une déformation 85 selon la direction longitudinale 50 des éléments 14, 15 peut être quantifiée par une mesure 90 des déformations grâce aux jauges de déformation. Cette mesure 90 peut être retournée à un comparateur 70 qui compare la valeur mesurée à la consigne initiale et adapte la tension d'alimentation du pont. L'actionneur 10 comprend un asservissement de la commande 21 en fonction d'une mesure de l'extension entre la base 11 et l'interface de sortie 13.

Dans le cas où il n'y a pas de commande commune 21 aux deux éléments 14 et 15, c'est-à-dire si les éléments 14 et 15 ont une commande séparée, l'actionneur 10 comporte alors une boucle par élément.

L'actionneur 10 selon l'invention dispose ainsi d'une grande course symétrique autour de sa position de référence. Il est athermique. Il possède une commande et un asservissement simples. Enfin, il occupe un volume raisonnable tout en ayant des caractéristiques de robustesse et de durée de vie compatibles avec une utilisation dans le domaine spatial.

## Revendications

1. Actionneur (10, 100) comprenant :
- une base (11)
- une structure intermédiaire (12),
- une interface de sortie (13),
- deux éléments (14, 15, 41, 42, 43) linéaires
produisant une extension contrôlable selon une même direction longitudinale (50), chacun entre une première et une seconde extrémité, un premier (14) des deux éléments possédant une première extrémité fixée sur la structure intermédiaire (12) et une seconde extrémité fixée sur la base (11), un second (15) des deux éléments possédant une première extrémité fixée sur la structure intermédiaire (12) et une seconde extrémité fixée à l'interface de sortie (13),
la base (11) et la structure intermédiaire (12) étant positionnées de façon à ce que l'extension contrôlable du second élément (15) produise un déplacement de l'interface de sortie (13) dans un premier sens (51) et l'extension contrôlable du premier élément (14) produise un déplacement de l'interface de sortie (13) dans un second sens (52) opposé au premier sens (51) par rapport à la base (11),
**caractérisé en ce que** l'actionneur (10) comprend des jauges de déformation (31, 32, 33, 34) montées sur les éléments (14, 15), **en ce que** les jauges (31, 32, 33, 34) sont connectées de façon à amplifier l'effet en vue d'une mesure (90) de l'extension entre la base (11) et l'interface de sortie (13),
**en ce qu'**il comporte une commande commune (21) aux deux éléments (14, 15, 41, 42, 43), **en ce que** la commande (21) est configurée de façon à avoir un premier effet parmi l'extension et la rétraction sur un élément (14, 42, 43) et un second effet parmi l'extension et la rétraction, inverse au premier effet, sur le second élément (15, 41),
**en ce que** la base (11), la structure intermédiaire (12), l'interface de sortie (13) et les deux éléments (14, 15, 41, 42, 43) forment plusieurs composants formant un empilage et **en ce qu'**il comporte une cale (20) de réglage thermique positionnée entre deux composants de l'empilage,
**en ce que** la structure intermédiaire (12) a une forme en U composée d'une partie centrale (60) parallèle à la direction longitudinale (50), d'une première partie (61) sur laquelle est fixé le second élément (15) et d'une seconde partie (62) parallèle à la première partie (61), sensiblement perpendiculaires à la partie centrale (60), et **en ce que** la cale (20) de réglage thermique est positionnée entre la seconde partie (62) et le premier élément (14).

2. Actionneur (10) selon la revendication 1, **caractérisé en ce que** la structure intermédiaire (12) est configurée de telle façon que le coefficient de dilatation thermique de l'actionneur (10) ait une valeur prédéterminée.

3. Actionneur (10, 100) selon l'une des revendications précédentes, **caractérisé en ce que** les éléments (14, 15, 41, 42, 43) sont à base de matériaux piézoélectriques, magnétostrictifs ou électrostrictifs.

4. Actionneur (10, 100) selon l'une des revendications précédentes, **caractérisé en ce que** les éléments (14, 15, 41, 42, 43) sont identiques.

5. Actionneur (10) selon l'une des revendications précédentes, **caractérisé en ce qu'**il comprend un asservissement de la commande (21) en fonction d'une mesure (90) de l'extension entre la base (11) et l'interface de sortie (13).

6. Utilisation d'un actionneur (10) selon la revendication 5, dont la commande commune (21) a une amplitude A, **caractérisée en ce qu'**elle consiste à définir une position de référence de l'actionneur (10) pour une valeur de commande égale à A/2.

## Patentansprüche

1. Aktuator (10, 100), umfassend:
- eine Basis (11)
- eine Übergangsstruktur (12),
- eine Ausgangsschnittstelle (13),
- zwei lineare Elemente (14, 15, 41, 42, 43), die eine kontrollierbare Extension gemäß einer selben Längsrichtung (50) produzieren, jeweils zwischen einem ersten und einem zweiten Ende, wobei ein erstes (14) der zwei Elemente ein erstes Ende besitzt, das an der Übergangsstruktur (12) befestigt ist, und ein zweites Ende, das an der Basis (11) befestigt ist, wobei ein zweites (15) der zwei Elemente ein erstes Ende besitzt, das an der Übergangsstruktur (12) befestigt ist, und ein zweites Ende, das an der Ausgangsschnittstelle (13) befestigt ist,
wobei die Basis (11) und die Übergangsstruktur (12) derart positioniert sind, dass die kontrollierbare Extension des zweiten Elements (15) eine Verlagerung der Ausgangsschnittstelle (13) in eine erste Richtung (51) produziert und die kontrollierbare Extension des ersten Elements (14) eine Verlagerung der Ausgangsschnittstelle (13) in eine zweite Richtung (52) entgegengesetzt zur ersten Richtung (51) in Bezug zur Basis (11) produziert,
**dadurch gekennzeichnet, dass** der Aktuator (10) Verformungsfühler (31, 32, 33, 34) umfasst, die auf den Elementen (14, 15) montiert sind, dass die Fühler (31, 32, 33, 34) derart angeschlossen sind, dass die Wirkung im Hinblick auf eine Messung (90) der Extension zwischen der Basis (11) und der Ausgangsschnittstelle (13) verstärkt wird,
dass er eine gemeinsame Steuerung (21) für zwei Elemente (14, 15, 41, 42, 43) aufweist, dass die Steuerung (21) derart konfiguriert ist, dass eine erste Wirkung von der Extension und dem Rückzug auf ein Element (14, 42, 43) und eine zweite Wirkung von der Extension und dem Rückzug, umgekehrt zur ersten Wirkung , auf das zweite Element (15, 41) entsteht,
dass die Basis (11), die Übergangsstruktur (12), die Ausgangsschnittstelle (13) und die zwei Elemente (14, 15, 41, 42, 43) mehrere Komponenten bilden, die einen Stapel bilden, und dass er eine thermischen Regelungskeil (20) aufweist, der zwischen zwei Stapelkomponenten positioniert ist,
dass die Übergangsstruktur (12) eine U-Form hat, gebildet aus einem zentralen Teil (60) parallel zur Längsrichtung (50), einem ersten Teil (61), auf dem das zweite Element (15) befestigt ist, und einem zweiten Teil (62) parallel zum ersten Teil (61), etwa senkrecht zum zentralen Teil (60), und dass der thermische Regelungskeil (20) zwischen dem zweiten Teil (62) und dem ersten Element (14) positioniert ist.

2. Aktuator (10) nach Anspruch 1, **dadurch gekennzeichnet, dass** die Übergangsstruktur (12) derart konfiguriert ist, dass der Koeffizient der thermischen Ausdehnung des Aktuators (10) einen vorbestimmten Wert hat.

3. Aktuator (10, 100) nach einem der vorangehenden Ansprüche, **dadurch gekennzeichnet, dass** die Elemente (14, 15, 41, 42, 43) auf der Basis piezoelektrischer, magnetostriktiver oder elektrostriktiver Materialien sind.

4. Aktuator (10, 100) nach einem der vorangehenden Ansprüche, **dadurch gekennzeichnet, dass** die Elemente (14, 15, 41, 42, 43) identisch sind.

5. Aktuator (10) nach einem der vorangehenden Ansprüche, **dadurch gekennzeichnet, dass** er eine Regelung der Steuerung (21) in Abhängigkeit von einer Messung (90) der Extension zwischen der Basis (11) und der Ausgangsschnittstelle (13) umfasst.

6. Verwendung eines Aktuators (10) nach Anspruch 5, dessen gemeinsame Steuerung (21) eine Amplitude A hat, **dadurch gekennzeichnet, dass** sie darin besteht, eine Referenzposition des Aktuators (10) für einen Steuerwert von gleich A/2 zu bestimmen.

## Claims

1. Actuator (10, 100) comprising:
- a base (11)
- an intermediate structure (12),
- an output interface (13),
- two linear elements (14, 15, 41, 42, 43) producing a controllable extension in the same longitudinal direction (50), each between a first and a second end, a first (14) of the two elements having a first end fixed onto the intermediate structure (12) and a second end fixed onto the base (11), a second (15) of the two elements having a first end fixed onto the intermediate structure (12) and a second end fixed to the output interface (13),
the base (11) and the intermediate structure (12) being positioned in such a manner that the controllable extension of the second element (15) produces a displacement of the output interface (13) in a first direction (51) and the controllable extension of the first element (14) produces a displacement of the output interface (13) in a second direction (52), opposite to the first direction (51), with respect to the base (11),
**characterized in that** the actuator (10) comprises deformation gauges (31, 32, 33, 34) mounted on the elements (14, 15), **in that** the gauges (31, 32, 33, 34) are connected so as to amplify the effect with a view to a measurement (90) of the extension between the base (11) and the output interface (13),
**in that** it comprises a control (21) common to the two elements (14, 15, 41, 42, 43), **in that** the control (21) is configured so as to have a first effect within the extension and the retraction on one element (14, 42, 43) and a second effect within the extension and the retraction, inverse to the first effect, on the second element (15, 41),
**in that** the base (11), the intermediate structure (12), the output interface (13) and the two elements (14, 15, 41, 42, 43) form several components forming a stack and **in that** it comprises a thermal regulation insert (20) positioned between two components of the stack,
**in that** the intermediate structure (12) has a U shape composed of a central part (60) parallel to the longitudinal direction (50), of a first part (61) onto which the second element (15) is fixed and of a second part (62) parallel to the first part (61), substantially perpendicular to the central part (60), and **in that** the thermal regulation insert (20) is positioned between the second part (62) and the first element (14).

2. Actuator (10) according to claim 1, **characterized in that** the intermediate structure (12) is configured in such a manner that the thermal expansion coefficient of the actuator (10) has a predetermined value.

3. Actuator (10, 100) according to one of the preceding claims, **characterized in that** the elements (14, 15, 41, 42, 43) are based on piezoelectric, magnetostrictive or electrostrictive materials.

4. Actuator (10, 100) according to one of the preceding claims, **characterized in that** the elements (14, 15, 41, 42, 43) are identical.

5. Actuator (10) according to one of the preceding claims, **characterized in that** it comprises a closed-loop feedback of the control (21) as a function of a measurement (90) of the extension between the base (11) and the output interface (13).

6. Use of an actuator (10) according to claim 5, whose common control (21) has an amplitude A, **characterized in that** it consists in defining a reference position of the actuator (10) for a control value equal to A/2.
